(19)

Europäisches Patentamt

European Patent Office

Office européen des brevets

(11) **EP 3 474 506 A1**

(12) **EUROPEAN PATENT APPLICATION**

(43) Date of publication:
**24.04.2019 Bulletin 2019/17**

(51) Int Cl.:
*H04L 25/02* (2006.01)          *H03M 1/00* (2006.01)
*H04B 7/08* (2006.01)

(21) Application number: **17197841.4**

(22) Date of filing: **23.10.2017**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(71) Applicant: **Intel IP Corporation
Santa Clara, CA 95054 (US)**

(72) Inventor: **ROTH, Kilian
80469 Muenchen (DE)**

(74) Representative: **Lambsdorff & Lange
Patentanwälte
Partnerschaft mbB
Grillparzerstraße 12A
81675 München (DE)**

(54) **TECHNIQUES FOR DIGITAL BEAMFORMING AND MIMO DETECTION**

(57)     This disclosure relates to a digital beamforming receiver device, comprising: a plurality of receive signal paths connectable to respective antenna ports of an antenna array, each receive signal path comprising: a radio frequency (RF) mixer configured to mix an RF signal received at a respective antenna port to generate a mixed RF signal, and an analog-to-digital converter (ADC) configured to convert the mixed RF signal into digital domain; and a coordinate descent detection logic, configured to detect a transmit symbol based on the ADC outputs of the plurality of receive signal paths.

400

Fig. 4

EP 3 474 506 A1

## Description

### FIELD

The disclosure relates to techniques for digital beamforming and multiple-input multiple-output (MIMO) detection. The disclosure particularly relates to a device and method for detecting a transmit symbol by a digital beamforming receiver and to a MIMO detection device, in particular related to robust massive MIMO multi user detection for millimeter wave systems with low resolution A/D conversion.

### BACKGROUND

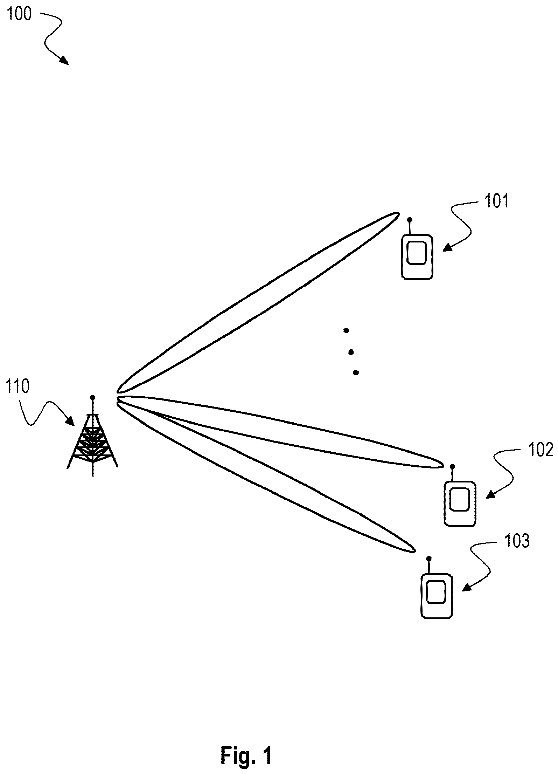

For future millimeter wave (mmWave) mobile broadband systems, analog/hybrid beamforming as schematically illustrated in Fig. 1 is considered to be a possible solution to the receiver power consumption of digital beamforming with high resolution analog-to-digital converters (ADCs) at the access point 110. Due to the large bandwidth, high-resolution ADCs require a significant amount of power. Therefore, they are considered to be a major contributor to the power consumption of a mmWave receiver. For such a system the number of antennas at the access point 110 is large, e.g. 64 or even 256. So the complexity for MU MIMO detection is relatively large. If the mmWave system is designed to have a limited power consumption, different non-linear impairments of the signal are expected. The disclosure presents a MIMO detection scheme that is robust to such impairments as well as channel estimation errors.

### BRIEF DESCRIPTION OF THE DRAWINGS

The accompanying drawings are included to provide a further understanding of embodiments and are incorporated in and constitute a part of this specification. The drawings illustrate embodiments and together with the description serve to explain principles of embodiments. Other embodiments and many of the intended advantages of embodiments will be readily appreciated as they become better understood by reference to the following detailed description.

Fig. 1 is a schematic diagram illustrating a beamforming system 100 with an exemplary number of one access point 110 (or base station) and multiple user equipments (UEs) 101, 102, 103.

Fig. 2 is a block diagram illustrating an analog beamforming receiver 200.

Fig. 3 is a block diagram illustrating a digital beamforming receiver device 300 according to the disclosure.

Fig. 4 is a block diagram illustrating a MIMO detection device 400 according to the disclosure giving further details about the block 309.

Fig. 5a is a performance diagram 500a illustrating performance of the digital beamforming receiver device for uncoded BER.

Fig. 5b is a performance diagram 500b illustrating performance of the digital beamforming receiver device for coded BER.

Fig. 6 is a histogram 600 illustrating the number of additions for sequential DCD with bound.

Fig. 7 is a block diagram illustrating a digital beamforming receiver device 700 according to the disclosure.

Fig. 8 is a schematic diagram illustrating a method 800 for detecting a transmit symbol by a digital beamforming receiver device according to the disclosure.

### DETAILED DESCRIPTION

In the following detailed description, reference is made to the accompanying drawings, which form a part thereof, and in which is shown by way of illustration specific aspects in which the invention may be practiced. It is understood that other aspects may be utilized and structural or logical changes may be made without departing from the scope of the present invention. The following detailed description, therefore, is not to be taken in a limiting sense, and the scope of the present invention is defined by the appended claims.

The following terms, abbreviations and notations will be used herein:

MIMO:      Multiple-Input Multiple-Output
DCD:       Dichotomous Coordinate Descent
ADC:       Analog-to-Digital Converter
HADC:      High-resolution ADC
LADC:      Low-resolution ADC
RF:        Radio Frequency
QAM:       Quadrature Amplitude Modulation
I:         In-phase component
Q:         Quadrature component
LO:        Local Oscillator
QAM:       Quadrature Amplitude Modulation
LTE:       Long Term Evolution
MMSE:      Minimum Mean Square Error
ML:        Maximum Likelihood

It is understood that comments made in connection with a described method may also hold true for a corresponding device configured to perform the method and vice versa. For example, if a specific method step is described, a corresponding device may include a unit to perform the described method step, even if such a unit is not explicitly described or illustrated in the figures. Further, it is understood that the features of the various exemplary aspects described herein may be combined with each other, unless specifically noted otherwise.

The techniques described herein may be implemented in wireless communication networks, in particular communication networks based on mobile communication standards such as LTE, in particular LTE-A and/or OFDM and successor standards such as 5G. The methods are also applicable for high speed communication standards from the 802.11 family according to the WiFi alliance, e.g. 802.11ad and successor standards. The methods and devices described below may be implemented in electronic devices such as access points and base stations or cellular handsets and mobile or wireless devices. The described devices may include integrated circuits and/or passives and may be manufactured according to various technologies. For example, the circuits may be designed as logic integrated circuits, analog integrated circuits, mixed signal integrated circuits, optical circuits, memory circuits and/or integrated passives.

A main idea of the disclosure is to utilize MIMO detection based on coordinate descend with binary step size for systems with low resolution ADCs. If the constellation is known and bounded (e.g. 4-QAM, 8-QAM, 16-QAM, 32-QAM, 64-QAM ...), the detection performance can be improved by restricting the detected symbols to the area defined by the constellation. The detected symbol can be generated iteratively with increasing accuracy.

The solution according to the disclosure has a reduced complexity (literally no multiplications are necessary) while at the same time it is robust to non-white noise/quantization error and channel estimation errors. At the moment different variants of MMSE detection with reduced complexity are considered for massive MIMO detection. These variants, however, have the drawback of assuming white noise. Considering the large overhead of whitening with a large number of antennas the complexity of this algorithm (Coordinate Descent) is even more appealing.

In the following, embodiments are described with reference to the drawings, wherein like reference numerals are generally utilized to refer to like elements throughout. In the following description, for purposes of explanation, numerous specific details are set forth in order to provide a thorough understanding of one or more aspects of embodiments. However, it may be evident to a person skilled in the art that one or more aspects of the embodiments may be practiced with a lesser degree of these specific details. The following description is therefore not to be taken in a limiting sense.

The various aspects summarized may be embodied in various forms. The following description shows by way of illustration various combinations and configurations in which the aspects may be practiced. It is understood that the described aspects and/or embodiments are merely examples, and that other aspects and/or embodiments may be utilized and structural and functional modifications may be made without departing from the scope of the present disclosure.

Fig. 1 is a schematic diagram illustrating a beamforming system 100. The beamforming system may include an exemplary number of one access point 110 (or base station) and multiple user equipments (UEs) 101, 102, 103. The beamforming system 100 is used for mobile broadband communications, in particular based on millimeter waves.

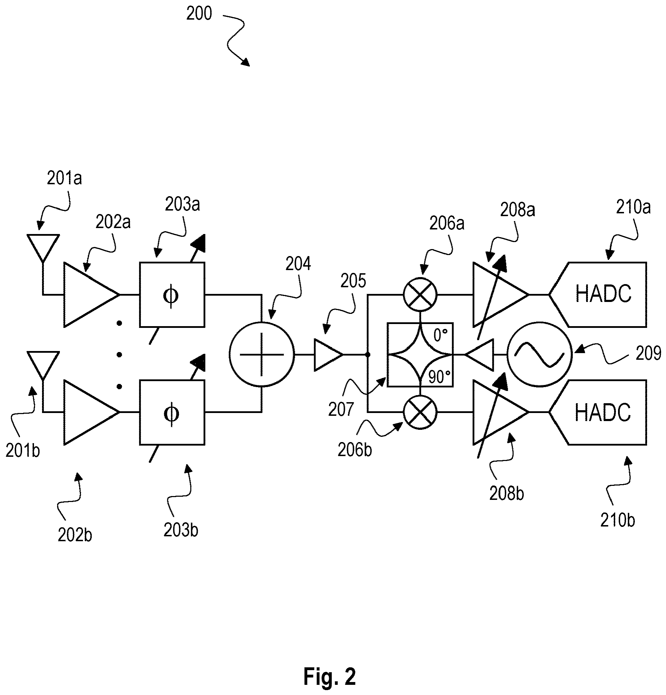

Fig. 2 is a block diagram illustrating an analog beamforming receiver 200. The analog beamforming receiver 200 includes a plurality of antenna ports 201a, 201b for receiving RF signals, respective amplifiers 202a, 202b for amplifying the RF signals and phase shifters 203a, 203b for applying respective phase shifts to the amplified RF signals, a signal adder 204 for adding the phase shifted signals and an amplifier 205 for amplifying the sum signal. The sum signal is passed to an analog front end, AFE (e.g. signal mixer and other processing components) 207 that mixes the sum signal with a local oscillator 209 signal. A first multiplier 206a provides the in-phase component and a second multiplier 206b provides the quadrature component of the mixed signal. Both components are amplified by respective amplifiers 208a, 208b and converted by respective analog-to-digital converters 210a, 210b with high resolution (HADC) into digital domain.

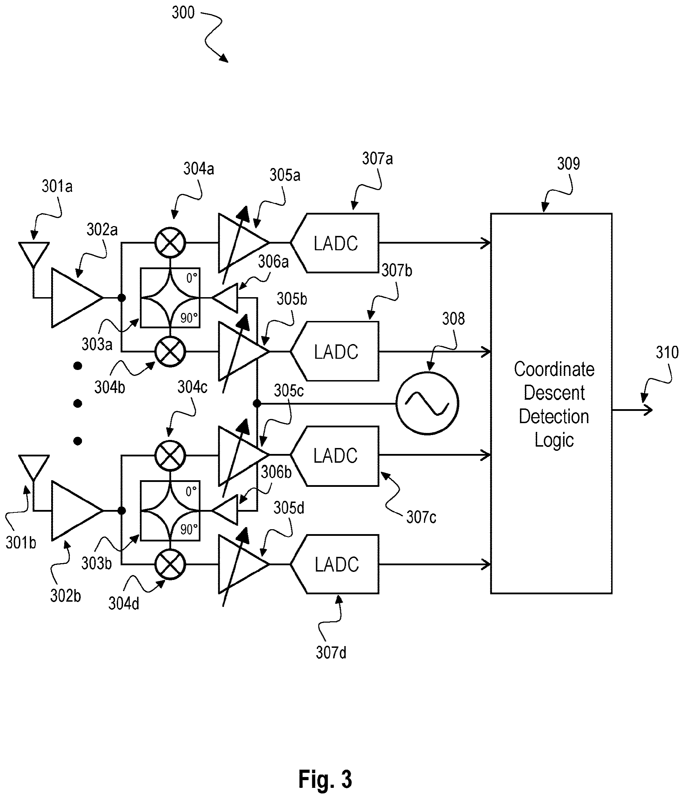

Analog/hybrid beamforming highly depends on the optimal alignment of beams and the corresponding setup of the phase shifters 203a, 203b. The required beam-training/alignment may be implemented as a search procedure, essentially different configurations can be tried and the best one selected. Considering such a procedure for multiple UEs 101, 102, 103 (see Fig. 1) at the same time may provide a large overhead. A solution to this type of systems is digital beamforming with low resolution ADCs as described below with respect to Fig. 3.

The analog beamforming receiver 200 may be adjusted to 802.11ad (WiGig) parameters, for example to 60 GHz, 2.5 GS/s, CMOS, 8 antennas. The HADCs 210a, 210b may have an exemplary resolution of 8 bit. Based on these parameters, an estimate for the power consumption of the amplifiers 202a, 202b is 5.4 mW; an estimate for the power consumption of the phase shifters 203a, 203b is 2 mW; an estimate for the power consumption of the amplifier 205 is 6 mW; an estimate for the power consumption of the HADCs 210a, 210b is 20 mW resulting in a total power consumption estimate of about 135 mW.

Fig. 3 is a block diagram illustrating a digital beamforming receiver device 300 according to the disclosure.

The digital beamforming receiver device 300 includes a plurality of antenna ports 301a, 301b for receiving RF signals, respective amplifiers 302a, 302b for amplifying the RF signals. The RF signal of each antenna path is passed to a respective analog front-end, AFE, (e.g. signal mixer and further processing) 303a, 303b that processes the RF signal with a local oscillator 308 signal for converting the RF signal to baseband (BB) or to intermediate frequency (IF). A first multiplier 304a, 304c of each AFE 303a, 303b provides the in-phase component and a second multiplier 304b, 304d provides the quadrature component of the respective mixed signal. Both components are amplified by respective amplifiers 305a, 305b, 305c, 305d and converted by respective analog-to-digital converters 307a, 307b, 307c, 307d with low resolution (LADC) into digital domain. Low resolution may be a resolution between 1 and 3 bits. The AFEs 303a, 303b are provided with a local oscillator signal from a local oscillator 308. The LO signals are amplified by respective LO signal amplifiers 306a, 306b.

The digital output signals of the LADCs 307a, 307b, 307c, 307d are provided to a coordinate descent detection logic 309 which is configured to detect the transmit symbol 310 (or an estimation thereof). The coordinate descent detection logic 309 may apply a dichotomous Coordinate Descent algorithm to detect the transmit symbol 310.

The digital beamforming receiver device 300 may be adjusted to 802.11ad (WiGig) parameters, for example to 60 GHz, 2.5 GS/s, CMOS, 8 antennas. The LADCs 307a, 307b may have an exemplary resolution of 2 bit, i.e. in a range between 1 to 3 bits. Based on these parameters, an estimate for the power consumption of each amplifier 305a, 305b, 305c, 305d is 2 mW; an estimate for the power consumption of each amplifier 306a, 306b is 3 mW; an estimate for the power consumption of the local oscillator 308 is 22.5 mW; an estimate for the power consumption of each LADC 307a, 307b, 307c, 307d is 0.15 mW, resulting in a total power consumption estimate of about 124 mW.

Due to the digital flexibility the performance with the same channel condition digital beamforming achieves a higher throughput over the analog beamforming receiver 200 depicted in Fig. 2, especially, in the per antenna SNR range from -30 to 10 dB. This SNR range is very likely to be encountered in a practical system.

In general A/D conversion introduces a noise that is dependent on the analog signal. In the case of high resolution ADCs 210a, 210b as shown in Fig. 2 this noise is much smaller than the thermal noise in the receiver and this effect can thus be ignored. For low resolution A/D 307a, 307b, 307c, 307d as shown in Fig. 3 2 regimes have to be distinguished: thermal noise limited and quantization error limited. In the thermal noise limited regime the thermal noise at the input of the ADC 307a, 307b, 307c, 307d is significantly larger than the signal. Thus, the quantization error is far smaller than the thermal noise, and since it mainly depends on the spatial white thermal noise it does not have a major influence on the system performance.

For the case where the signal is dominating the signal before the A/D conversion 307a, 307b, 307c, 307d, it is necessary to consider the specific properties of the quantization error. Since the quantization error is dependent on the receive signal it is not spatially white anymore. The probability density function (pdf) of the error is also not Gaussian, but when considering an OFDM system, the quantization error in the frequency domain is approximately Gaussian distributed. This is the case because due to the Central Limiting Theorem (CLT) the sum of independent random variables converges to a Gaussian distribution.

For such a system the number of antennas at the access point can be large, e.g. 64 or even 256. So the complexity for MU MIMO detection is relatively large. If the mmWave system is designed to have a limited power consumption, different non-linear impairments of the signal may occur. Therefore, an appropriate MIMO detection scheme is required. The coordinate descent detection logic 309 provides a suitable scheme that is robust to such impairments as well as channel estimation errors.

The classical problem of ML detection can be formulated as

$$\hat{\boldsymbol{x}} = \operatorname*{argmin}_{x_n \in \mathbb{X}} ||\boldsymbol{y} - \boldsymbol{H}\boldsymbol{x}||_2^2 ,$$

where $\mathbb{X}$ is the set containing all possible transmit symbols (usually an x-QAM constellation) The symbols $\boldsymbol{x}$, $\boldsymbol{H}$ and $\boldsymbol{y}$ represent the transmit symbol, the channel and the receive symbol of the system. The complexity of this discrete optimization problem grows exponentially with the dimensionality of $\boldsymbol{x}$. Thus, for higher number of spatial streams as envisioned for massive MIMO it is not feasible to solve this problem.

Fortunately, as the number of receivers grows large with respect to the number of simultaneously served UEs the MMSE solution to the relaxed optimization problem

$$\hat{\boldsymbol{x}} = \operatorname{argmin} \mathbb{E}\left[ ||\boldsymbol{y} - \boldsymbol{H}\boldsymbol{x}||_2^2 \right] ,$$

 approaches the performance of the ML detection at a much lower computational cost. Unfortunately, the close form solution to this problem requires knowledge about the noise covariance matrix. For a system with a large number of antennas this is hard to attain.

The ML detection problem can be relaxed in a way that reduces the complexity, but not making any assumptions on the noise statistics:

$$\hat{\boldsymbol{x}} = \operatorname*{argmin}_{\Re(x_n) \in [-B,B], \; \Im(x_n) \in [-B,B]} ||\boldsymbol{y} - \boldsymbol{H}\boldsymbol{x}||_2^2 .$$

The variable $B$ forces each element of the vector $\boldsymbol{x}$ to be in the range of -$B$ to $B$. In the following paragraphs it is shown how to solve this optimization problem efficiently and that there is no need to make any assumption on the noise statistics.

This problem can be reformulated into solving the following linear system of equations:

$$\boldsymbol{H}^H \boldsymbol{H} \boldsymbol{x} = \boldsymbol{H}^H \boldsymbol{y}.$$

Thus, a coordinate descend based method can be utilized to solve this problem. To reduce the complexity the stepsize can be selected to be of the form $2^{-l}$, where $l$ is an integer. This has the advantage that all multiplications with this number can be implemented as bit shifts. The algorithm (denoted as "Sequential DCD with bound") can be used for the scenario of multi user detection in a CDMA system and is shown below.

---
**Algorithm 3** Sequential DCD with bound
---

$\quad$ **Require:** $A$, $b$, $N$, $H$, $B$, $N_u$, $M_b$
$\quad$ **Initialization:** $x \leftarrow 0$, $r \leftarrow b$, $\alpha \leftarrow H$, $m \leftarrow 0$,
$\quad$ UpdateFlag $\leftarrow$ false, $k \leftarrow 0$
$\quad$ **while** $m < M_b$ **do**
$\qquad$ **for** $n \in \{1, \cdots, N\}$ **do**
$\qquad\qquad$ **if** $\alpha/2[A]_{n,n} < |[r]_n|$ **then**
$\qquad\qquad\qquad$ $xt \leftarrow [x]_n + \text{sign}([r]_n)\alpha$
$\qquad\qquad\qquad$ **if** $xt \le B$ **then**
$\qquad\qquad\qquad\qquad$ $[x]_n \leftarrow xt$
$\qquad\qquad\qquad\qquad$ $r \leftarrow r - \text{sign}([r]_n)\alpha a_n$
$\qquad\qquad\qquad\qquad$ UpdateFlag $\leftarrow$ true, $k \leftarrow k + 1$
$\qquad\qquad\qquad$ **end if**
$\qquad\qquad$ **end if**
$\qquad$ **end for**
$\qquad$ **if** $k \ge N_u$ **then**
$\qquad\qquad$ **return** $x$, $r$
$\qquad$ **end if**
$\qquad$ **if** UpdateFlag **then**
$\qquad\qquad$ UpdateFlag $\leftarrow$ false
$\qquad$ **else**
$\qquad\qquad$ $m \leftarrow m + 1$, $\alpha \leftarrow \alpha/2$
$\qquad$ **end if**
$\quad$ **end while**
$\quad$ **return** $x$, $r$

---

The parameters $H$, $B$, $N_u$ and $M_b$ are the maximum stepsize, the upper bound, the maximum number of updates and the maximum number of updates of the algorithm. The parameter $B$ can be chosen in a way to just accommodate the QAM constellation in the scaling before the data detection. If the detected symbols cannot be bounded, for example when doing frequency domain equalization of DFT-s-OFDM or a signal carrier system this constraint can be either removed by setting $B$ to infinity, or by setting it to the largest value that should be received. The value of $H$ can be of the form $2^{-l}$, where $l$ is an integer. The largest stepsize $H$ can be chosen smaller than the bound $B$.

Further variants of this algorithm (denoted as "Leading DCD", "Sequential DCD" and "Leading DCD with bound") are shown in the following:

---
**Algorithm 1** Leading DCD
---

$\quad$ **Require:** $A$, $b$, $H$, $N_u$, $M_b$
1: $\quad$ **Initialization:** $x \leftarrow 0$, $r \leftarrow b$, $\alpha \leftarrow H$, $m \leftarrow 0$
2: $\quad$ **for** $k \leftarrow 1$ to $N_u$ **do**
3: $\qquad$ $p \leftarrow \underset{i = \{1, \cdots, M\}}{\text{argmax}} [r]_i$
4: $\qquad$ **while** $|[r]_p| \le (\alpha/2)[A]_{p,p}$ **do**
5: $\qquad\qquad$ $m \leftarrow m + 1$, $\alpha \leftarrow \alpha/2$
6: $\qquad\qquad$ **if** $m > M_b$ **then**
7: $\qquad\qquad\qquad$ **return** $x$, $r$
8: $\qquad\qquad$ **end if**
9: $\qquad$ **end while**
10: $\qquad$ $[x]_p \leftarrow [x]_p + \text{sign}([r]_p)\alpha$, $r \leftarrow r - \text{sign}([r]_p)\alpha a_p$
11: $\quad$ **end for**
12: $\quad$ **return** $x$, $r$

---

---

**Algorithm 2** Sequential DCD

---

**Require:** $A$, $b$, $N$, $H$, $N_u$, $M_b$
**Initialization:** $x \leftarrow 0$, $r \leftarrow b$, $\alpha \leftarrow H$, $m \leftarrow 0$,
UpdateFlag $\leftarrow$ false, $k \leftarrow 0$
**while** $m < M_b$ **do**
    **for** $n \in \{1, \cdots, N\}$ **do**
        **if** $\alpha/2 [A]_{n,n} < |[r]_n|$ **then**
            $[x]_n \leftarrow [x]_n + \mathrm{sign}([r]_n)\alpha$
            $r \leftarrow r - \mathrm{sign}([r]_n)\alpha a_n$
            UpdateFlag $\leftarrow$ true, $k \leftarrow k + 1$
        **end if**
    **end for**
    **if** $k \geq N_u$ **then**
        **return** $x$, $r$
    **end if**
    **if** UpdateFlag **then**
        UpdateFlag $\leftarrow$ false
    **else**
        $m \leftarrow m + 1$, $\alpha \leftarrow \alpha/2$
    **end if**
**end while**
**return** $x$, $r$

---

---

**Algorithm 4** Leading DCD with bound

---

**Require:** $A$, $b$, $N$, $H$, $B$, $N_u$, $M_b$
1: **Initialization:** $x \leftarrow 0$, $r \leftarrow b$, $\alpha \leftarrow H$, $m \leftarrow 0$
2: $\mathbb{I} \leftarrow \{1, \cdots, N\}$
3: **for** $k \leftarrow 1$ to $N_u$ **do**
4:     $p \leftarrow \underset{i \in \mathbb{I}}{\mathrm{argmax}}[r]_i$
5:     **while** $|[r]_p| \leq (\alpha/2)[A]_{p,p}$ **do**
6:         $m \leftarrow m + 1$, $\alpha \leftarrow \alpha/2$
7:         $\mathbb{I} \leftarrow \{1, \cdots, N\}$
8:         **if** $m > M_b$ **then**
9:             **return** $x$, $r$
10:         **end if**
11:     **end while**
12:     $xt \leftarrow [x]_p + \mathrm{sign}([r]_p)\alpha$
13:     **if** $xt \leq B$ **then**
14:         $[x]_p \leftarrow xt$
15:         $r \leftarrow r - \mathrm{sign}([r]_p)\alpha a_p$
16:     **else**
17:         $\mathbb{I} \leftarrow \mathbb{I} \setminus p$
18:     **end if**
19: **end for**
20: **return** $x$, $r$

---

The symbols $A$, $b$ and $N$ are the elements of the linear system of equations

$$Ax = b,$$

and the size of it. The values $x$ and $r$ are the result and the residual error. Since the DCD algorithms shown above only solve real systems there is a need to setup the *A* and *b* in the following way:

$$A = \begin{bmatrix} \Re(H^H H) & -\Im(H^H H) \\ \Im(H^H H) & \Re(H^H H) \end{bmatrix}, b = \begin{bmatrix} \Re(H^H y) \\ \Im(H^H y) \end{bmatrix}.$$

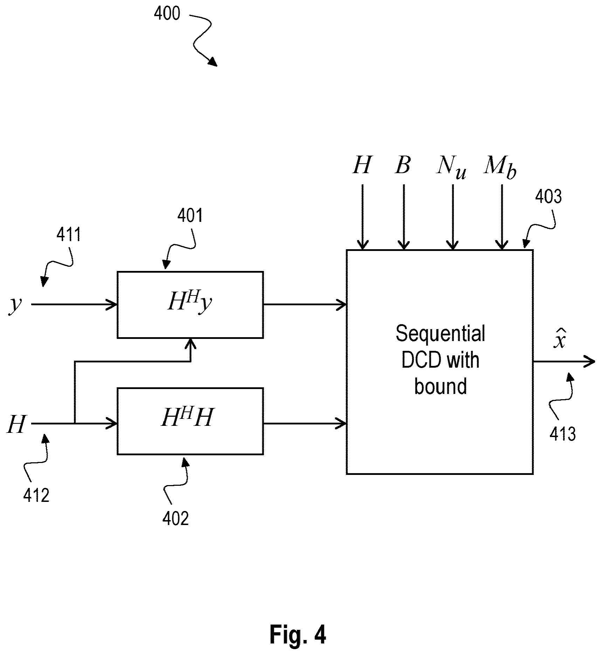

Since the considered system is split into real and imaginary part the value of *N* is double the number of UE/spatial streams to be detected. The resulting value of *x* is also going to be split between real and imaginary in the same fashion as *b*. The block diagram in Figure 4 shows the result of the MIMO detection.

Fig. 4 is a block diagram illustrating a MIMO detection device 400 according to the disclosure. The MIMO detection device 400 includes a first logic 402 configured to determine a gram matrix, $H^H H$ of a MIMO channel, H. The MIMO channel may be expressed by its channel matrix H. The MIMO channel may be a channel estimate estimated by a channel estimator. The device 400 includes a second logic 401 configured to determine a product of the Hermitian MIMO channel, $H^H$ and a receive symbol, y. The MIMO detection device 400 includes a third logic 403 configured to detect a transmit symbol, x based on a Dichotomous Coordinate Descent algorithm (DCD) applied to outputs of the first logic and the second logic, e.g. as described above with respect to Fig. 3.

The third logic 403 may detect the transmit symbol based on one of the following variants of DCD as described above with respect to Fig. 3: Leading DCD, Sequential DCD, Sequential DCD with bound, Leading DCD with bound. The third logic 403 may receive the MIMO channel H, as a parameter, e.g. from a channel estimator. The third logic 403 may receive a bound parameter, B indicating a size restriction of the detected transmit symbol. The bound parameter, B may range within an area defined by a predefined constellation. The predefined constellation may for example be 4-QAM, 8-QAM, 16-QAM, 32-QAM, 64-QAM or higher.

The third logic 403 may detect the transmit symbol x based on solving the following linear system of equations: $H^H Hx = H^H y$., where H denotes the channel and y denotes the receive symbol, e.g. as described above with respect to Fig. 3.

The MIMO detection device 400 may include a channel estimator, configured to determine the MIMO channel H based on the receive symbol, y and knowledge (e.g. a pilot pattern) about the transmit symbol, x.

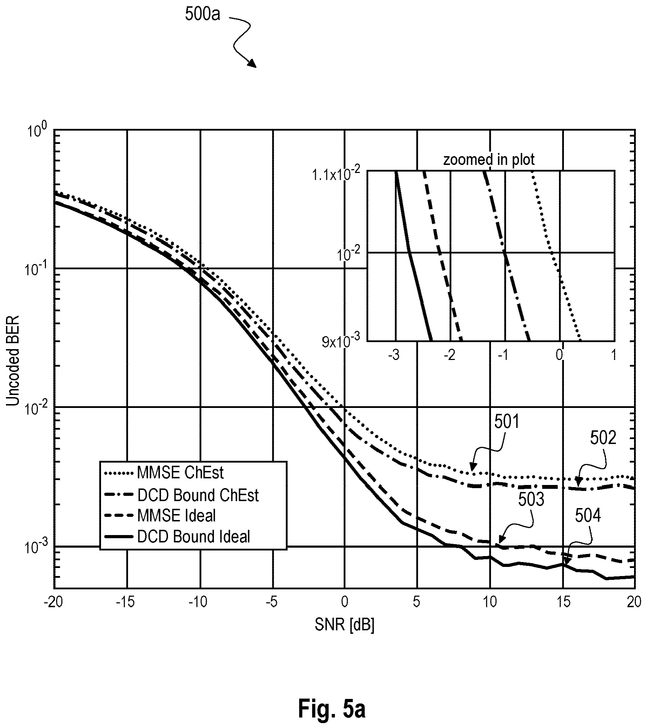

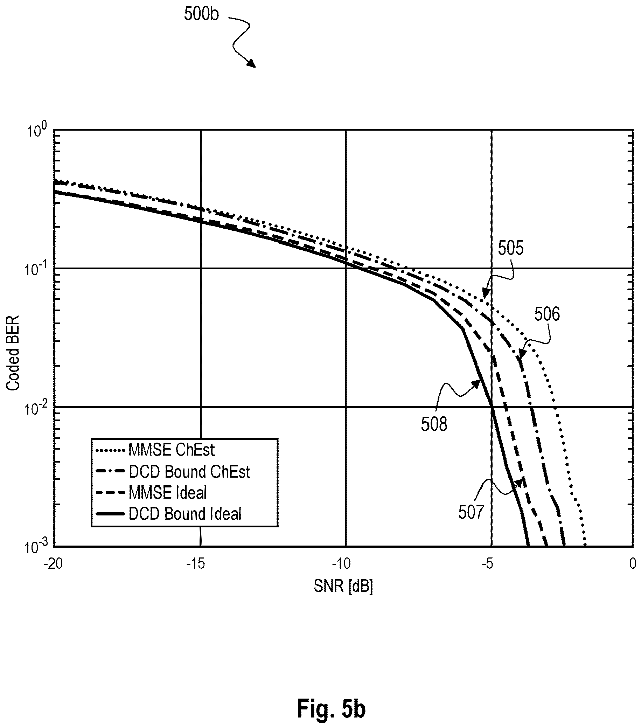

Figures 5a and 5b are performance diagrams 500a illustrating performance of the digital beamforming receiver device for uncoded BER (Fig. 5a) and coded BER (Fig. 5b). Graphs 501, 505 show the performance of MMSE channel estimation. Graphs 502, 506 show performance of DCD Bound Channel estimation. Graphs 503, 507 show performance of MMSE ideal. Graphs 504, 508 show performance of DCD Bound ideal.

Table 1 shows parameters that were applied for the simulation of the digital beamforming receiver device.

Table 1 Simulation parameters

| parameter | description |
|---|---|
| Reference signals | 5G NR OFDM DMRS type 1 |
| Channel estimation | 2D MMSE and Ideal |
| Number of Users | 8 |
| Number of receive antennas | 64 |
| Channel model | Exponential PDP (no Doppler spread) |
| SNR definition | average per user per antenna |
| Channel code | LTE turbo code rate 0.9 |
| MIMO detection algorithms | MMSE/DCD-Bound |
| ADC resolution | 2 bit |
| Modulation format | 16 QAM |

Additional whitening of the MMSE MIMO detection did not provide any additional gains, but does increase the complexity dramatically. The simulation results in Figures 5a and 5b show that in the given example with actual channel estimation the performance of the DCD algorithm achieves about 1dB gain and uncoded BER of $10^{-2}$. To highlight that this result also transfers to the coded BER the result for a relatively high coding rate of 0.90 is shown. It is also important to mention that the saturation of the uncoded BER is caused by the quantization error introduced by the 2-bit ADC.

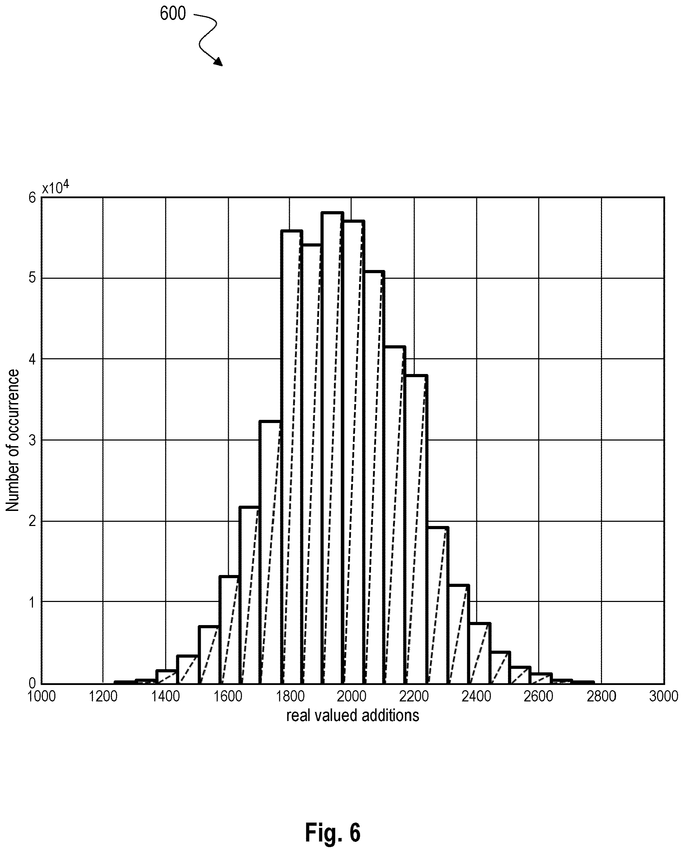

Fig. 6 is a histogram 600 illustrating the number of additions for sequential DCD with bound.

Since the presented algorithm has no multiplications, the complexity can be compared to an MMSE based implementation by mapping additions and multiplications to logic operations. The following mapping of additions and multiplications to logic gates as shown in Table 2 can be applied:

Table 2: mapping of additions and multiplications to logic operations

| Operation | Number of NAND2 gates |
|---|---|
| 18 bit Adder | 125 |
| 18 bit Signed Multiplication | 2200 |

The histogram 600 in Figure 6 shows the number of additions used to equalize one subcarrier for the simulation parameters presented above with respect to Figures 5a and 5b. The comparisons are implemented as a subtraction followed by checking if the sign bit is checked or not. Therefore they are counted to have equal complexity compared to an addition. The number of comparisons is low compared to additions used for updating the residual vector $r$. The average complexity is 1972 real additions. For simplicity one can use 2000 for the following analysis.

To compare the MMSE to the algorithm as presented in this disclosure the following two scenarios can be compared. In the first scenario the matrix computed to generate the MMSE result is calculated separately for each subcarrier (scenario 1). In the second case it is assumed that the matrix can be reused to detect the symbol in 14 consecutive OFDM symbols on the same subcarrier (scenario 2) .

There are few common operations to both systems. The complexity is developed for all these computations to then compare the overall complexity.

From Table 3 below it is easy to see that even just the multiplication with the already inverted matrix is more complex than solving the linear system of equations with the Sequential DCD algorithm with bound.

Table 3: Complexity of different operations

| Operations | Real additions | real multiplications | Logic operations |
|---|---|---|---|
| Computation Gram matrix using symmetry $H^HH$ | 8128 | 8192 | 19038400 |
| Match Filter $H^Hy$ | 2032 | 2048 | 5521600 |
| Additon of Noise Covariance $H^HH + I$ | 16 | 0 | 2000 |
| Matrix Inversion $(H^HH+I)^{-1}$ | 1700 | 1900 | 4392500 |
| Multiplication with inverse matrix $(H^HH+I)^{-1} H^Hy$ | 240 | 256 | 593200 |
| Sequential DCD with bound | 2000 | 0 | 250000 |

As can be seen from Table 3, the complexity is dominated by the computation of the Gram matrix. Therefore the overall computational complexity of the disclosed approach compared to MMSE is reduced while at the same time the performance is also improved. In the first scenario the improvement is about 16% in the second it is in the range of 10% as can be seen from Table 4 below.

Table 4: Complexity of the 2 presented scenarios

| Detection algorithm | scenario 1 | scenario 2 |
|---|---|---|
| MMSE | 29547700 | 109040100 |
| Sequential DCD with bound | 24810000 | 99840800 |

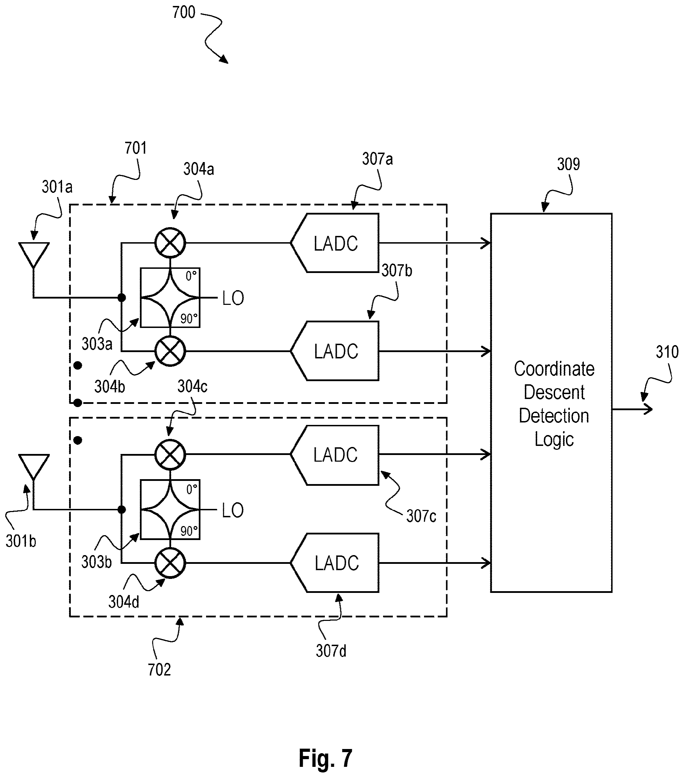

Fig. 7 is a block diagram illustrating a digital beamforming receiver device 700 according to the disclosure. With respect to Fig. 3, the digital beamforming receiver device 700 describes the basic version of a digital beamforming receiver while the digital beamforming receiver device 300 is a specific version of the digital beamforming receiver device 700.

The digital beamforming receiver device 700 includes a plurality of receive signal paths 701, 702 connectable to respective antenna ports 301a, 301b of an antenna array. Each receive signal path 701, 702 includes a radio frequency (RF) front-end (e.g. a mixer and other processing components) 303a, 303b that is configured to convert the RF signal received at a respective antenna port 301a, 301b into digital domain. Each receive signal path 701, 702 includes an analog-to-digital converter (ADC) 307a, 307b, 307c, 307d configured to convert the analog signal into digital domain. The digital beamforming receiver device 700 further includes a coordinate descent detection logic 309, configured to detect a transmit symbol 310 based on the ADC outputs of the plurality of receive signal paths 701, 702.

The coordinate descent detection logic 309 may detect the transmit symbol 310 based on a Dichotomous Coordinate Descent algorithm (DCD), e.g. as described above with respect to Fig. 3. The coordinate descent detection logic 309 may detect the transmit symbol 310 based on one of the following variants of DCD as described above with respect to Fig. 3: Leading DCD, Sequential DCD, Sequential DCD with bound, Leading DCD with bound.

The coordinate descent detection logic 309 may detect the transmit symbol 310 based on a coordinate descent algorithm with binary step size. The coordinate descent detection logic 309 may implement multiplications as bit shifts in order to reduce computational complexity. The coordinate descent detection logic 309 may restrict a size of the detected transmit symbol 310 in order to reduce computational complexity. The size of the detected transmit symbol 310 may for example be restricted to an area defined by a predefined constellation, e.g. a 4-QAM, 8-QAM, 16-QAM, 32-QAM, 64-QAM or higher.

The ADC 307a, 307b, 307c, 307d may be or include a low resolution ADC, e.g. as described above with respect to Fig. 3. A resolution of the low resolution ADC 307a, 307b, 307c, 307d may for example be 1, 2 or 3 bit.

The digital beamforming receiver device 700 may include a digital receiver including a channel estimator configured to estimate a channel. The coordinate descent detection logic 309 may detect the transmit symbol 310 based on the channel, e.g. as described above with respect to Figs. 3 and 4. The coordinate descent detection logic 309 may detect the transmit symbol x, 310 based on solving the following linear system of equations: $H^H H x = H^H y$., where H denotes the channel and y denotes the receive symbol, e.g. as described above with respect to Figs. 3 and 4.

The analog front end, AFE 303a, 303b may include a complex RF mixer configured to generate a mixed RF signal having an in-phase (I) component and a quadrature (Q) component. The ADC 307a, 307b, 307c, 307d may be configured to separately convert the I component and the Q component of the mixed RF signal into digital domain. For example, ADC 307a converts in-phase component of first signal path 701, ADC 307b converts quadrature component of first signal path 701, ADC 307c converts in-phase component of n-th signal path 702 and ADC 307d converts quadrature component of n-th signal path 702 into digital domain. The digital beamforming receiver device 700 may include a local oscillator 308 configured to provide the AFEs 303a, 303b of all receive signal paths 701, 702 with an LO signal.

Each receive signal path 701, 702 may include an amplifier 305a, 305b, 305c, 305d (shown in Fig. 3) coupled between the AFE 303a, 303b and the ADC 307a, 307b, 307c, 307d. This amplifier is configured to match the AFE output signal to a dynamic range of the ADC input.

The antenna array may be configured to receive millimeter wave RF signals. However, the antenna array may also receive centimeter wave RF signals.

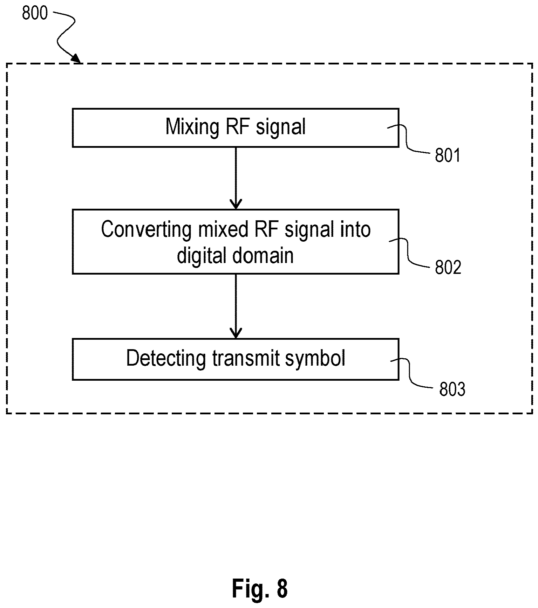

Fig. 8 is a schematic diagram illustrating a method 800 for detecting a transmit symbol by a digital beamforming receiver device according to the disclosure, e.g. a digital beamforming receiver device 300, 700 as described above with respect to Figures 3 and 7. The digital beamforming receiver device 300, 700 includes a plurality of receive signal paths 701, 702 that are connectable to respective antenna ports 301a, 301b of an antenna array, e.g. as shown in Fig. 7.

The method 800 includes: converting, e.g. mixing 801, by an analog front end (e.g. radio frequency (RF) mixer and other processing components) 303a, 303b of a respective receive signal path 701, 702, an RF signal received at the antenna port 301a, 301b of the respective receive signal path 701, 702 to an analog baseband or intermediate frequency signal, e.g. as described above with respect to Figures 3 and 7. The method 800 includes: converting 802, by an analog-to-digital converter (ADC) 307a, 307b, 307c, 307d of the respective receive signal path 701, 702, the analog baseband or intermediate frequency signal, i.e. the mixed RF signal, into digital domain, e.g. as described above with respect to Figures 3 and 7. The method 800 includes: detecting 803, by a coordinate descent detection logic, a transmit symbol based on the ADC outputs of the plurality of receive signal paths, e.g. as described above with respect to Figures 3 and 7.

The method 800 may further include: detecting the transmit symbol based on a Dichotomous Coordinate Descent algorithm (DCD). The method 800 may further include: detecting the transmit symbol based on one of the following variants of DCD: Leading DCD, Sequential DCD, Sequential DCD with bound, Leading DCD with bound, e.g. as described above with respect to Figures 3 and 7.

The method 800 may further include: detecting the receive symbol based on a coordinate descent algorithm with binary step size. The method 800 may further include: implementing multiplications as bit shifts. The method 800 may further include: restricting a size of the detected transmit symbol, e.g. as described above with respect to Figures 3 and 7. The size of the detected transmit symbol may be restricted to an area defined by a predefined constellation, e.g. 4-QAM, 8-QAM, 16-QAM, 32-QAM, 64-QAM or higher.

The method 800 may include: estimating a channel; and detecting the transmit symbol based on the channel. The method 800 may include: detecting the transmit symbol x based on solving the following linear system of equations:

$H^H Hx = H^H y.$, where H denotes the channel and y denotes the receive symbol, e.g. as described above with respect to Figures 3 and 7.

The devices and systems described in this disclosure may be implemented as Digital Signal Processors (DSP), microcontrollers or any other side-processor or hardware circuit on a chip or an application specific integrated circuit (ASIC) .

Embodiments described in this disclosure can be implemented in digital electronic circuitry, or in computer hardware, firmware, software, or in combinations thereof, e.g. in available hardware of mobile devices or in new hardware dedicated for processing the methods described herein.

The present disclosure also supports a computer program product including computer executable code or computer executable instructions that, when executed, causes at least one computer to execute the performing and computing blocks described herein, in particular the methods 200, 300, 500 described above with respect to Figs. 2, 3 and 5 and the computing blocks described above with respect to Figure 4. Such a computer program product may include a non-transient readable storage medium storing program code thereon for use by a processor, the program code comprising instructions for performing the methods or the computing blocks as described above.

## EXAMPLES

The following examples pertain to further embodiments. Example 1 is a digital beamforming receiver device, comprising: a plurality of receive signal paths connectable to respective antenna ports of an antenna array, each receive signal path comprising: a radio frequency (RF) front-end configured to convert a received RF signal to an analog baseband; and an analog-to-digital converter (ADC) configured to convert the analog signal into digital domain; and a coordinate descent detection logic, configured to detect a transmit symbol based on the ADC outputs of the plurality of receive signal paths.

In Example 2, the subject matter of Example 1 can optionally include that each receive signal path comprises an amplifier coupled between the RF front-end and the ADC, wherein the amplifier is configured to match the RF front-end output signal to a dynamic range of the ADC input.

In Example 3, the subject matter of any one of Examples 1-2 can optionally include that the ADC comprises a low resolution ADC.

In Example 4, the subject matter of Example 3 can optionally include that a resolution of the low resolution ADC is an ADC that does not fully cover the dynamics of the analog signal at its input.

In Example 5, the subject matter of any one of Examples 1-4 can optionally include that the antenna array is configured to receive millimeter wave RF signals.

In Example 6, the subject matter of any one of Examples 1-5 can optionally include that the coordinate descent detection logic is configured to detect the transmit symbol based on a Dichotomous Coordinate Descent algorithm (DCD).

In Example 7, the subject matter of Example 6 can optionally include that the coordinate descent detection logic is configured to detect the transmit symbol based on one of the following variants of DCD: Leading DCD, Sequential DCD, Sequential DCD with bound, Leading DCD with bound.

In Example 8, the subject matter of any one of Examples 1-7 can optionally include that the coordinate descent detection logic is configured to detect the transmit symbol based on a coordinate descent algorithm with binary step size.

In Example 9, the subject matter of Example 8 can optionally include that the coordinate descent detection logic is configured to implement multiplications as bit shifts.

In Example 10, the subject matter of any one of Examples 1-9 can optionally include that the coordinate descent detection logic is configured to restrict a size of the detected transmit symbol.

In Example 11, the subject matter of Example 10 can optionally include that the size of the detected transmit symbol is restricted to an area defined by a predefined constellation.

In Example 12, the subject matter of Example 11 can optionally include that the predefined constellation is from the following: 4-QAM, 8-QAM, 16-QAM, 32-QAM, 64-QAM and higher.

In Example 13, the subject matter of Example 3 can optionally include that a resolution of the low resolution ADC is 1, 2 or 3 bit.

In Example 14, the subject matter of any one of Examples 1-13 can optionally include a digital receiver comprising a channel estimator configured to estimate a channel, wherein the coordinate descent detection logic is configured to detect the transmit symbol based on the channel.

In Example 15, the subject matter of Example 14 can optionally include that the coordinate descent detection logic is configured to detect the transmit symbol x based on solving the following linear system of equations: $H^H Hx = H^H y.$ , where H denotes the channel and y denotes the receive symbol.

In Example 16, the subject matter of any one of Examples 1-15 can optionally include that the RF mixer comprises a complex RF mixer configured to generate a mixed RF signal having an in-phase (I) component and a quadrature (Q) component.

In Example 17, the subject matter of Examples 16 can optionally include that the ADC is configured to separately convert the I component and the Q component of the mixed RF signal into digital domain.

In Example 18, the subject matter of any one of Examples 1-17 can optionally include a local oscillator configured to provide the RF mixers of all receive signal paths with an LO signal.

In Example 19, the subject matter of any one of Examples 1-18 can optionally include that each receive signal path comprises an amplifier coupled between the RF mixer and the ADC, wherein the amplifier is configured to match the RF mixer output signal to a dynamic range of the ADC input.

In Example 20, the subject matter of any one of Examples 1-19 can optionally include that the antenna array is configured to receive millimeter wave RF signals.

Example 21 is a multiple-input multiple-output (MIMO) detection device, comprising: a first logic configured to determine a gram matrix, $H^HH$ of a MIMO channel, H; a second logic configured to determine a product of the Hermitian MIMO channel, $H^H$ and a receive symbol, y; and a third logic configured to detect a transmit symbol, x based on a Dichotomous Coordinate Descent algorithm (DCD) applied to outputs of the first logic and the second logic.

In Example 22, the subject matter of Example 21 can optionally include that the third logic is configured to detect the transmit symbol based on one of the following variants of DCD: Leading DCD, Sequential DCD, Sequential DCD with bound, Leading DCD with bound.

In Example 23, the subject matter of any one of Examples 21-22 can optionally include that the third logic is configured to receive a bound parameter, B indicating a size restriction of the detected transmit symbol.

In Example 24, the subject matter of Example 23 can optionally include that the bound parameter, B ranges within an area defined by a predefined constellation.

In Example 25, the subject matter of Example 24 can optionally include that the predefined constellation is from the following: 4-QAM, 8-QAM, 16-QAM, 32-QAM, 64-QAM and higher. Alternatively a DFT-s-OFDM system can be applied having a predefined constellation at the stage of MIMO detection.

In Example 26, the subject matter of any one of Examples 21-25 can optionally include that the third logic is configured to detect the transmit symbol x based on solving the following linear system of equations: $H^HHx = H^Hy.$, where H denotes the channel and y denotes the receive symbol.

In Example 27, the subject matter of any one of Examples 21-26 can optionally include: a channel estimator, configured to determine the MIMO channel based on the receive symbol, y and knowledge about the transmit symbol, x.

Example 28 is a method for detecting a transmit symbol by a digital beamforming receiver device comprising a plurality of receive signal paths connectable to respective antenna ports of an antenna array, the method comprising: converting a received RF signal, by a radio frequency (RF) front-end, to an analog baseband or intermediate frequency signal; converting, by an analog-to-digital converter (ADC) of the respective receive signal path, the analog baseband or intermediate frequency signal into digital domain; and detecting, by a coordinate descent detection logic, a transmit symbol based on the ADC outputs of the plurality of receive signal paths.

In Example 29, the subject matter of Example 28 can optionally include: detecting the transmit symbol based on a Dichotomous Coordinate Descent algorithm (DCD).

In Example 30, the subject matter of Example 29 can optionally include: detecting the transmit symbol based on one of the following variants of DCD: Leading DCD, Sequential DCD, Sequential DCD with bound, Leading DCD with bound.

In Example 31, the subject matter of any one of Examples 28-30 can optionally include: detecting the receive symbol based on a coordinate descent algorithm with binary step size.

In Example 32, the subject matter of Example 31 can optionally include: implementing multiplications as bit shifts.

In Example 33, the subject matter of any one of Examples 26-32 can optionally include: restricting a size of the detected transmit symbol.

In Example 34, the subject matter of Example 33 can optionally include that the size of the detected transmit symbol is restricted to an area defined by a predefined constellation.

In Example 35, the subject matter of Example 34 can optionally include that the predefined constellation is from the following: 4-QAM, 8-QAM, 16-QAM, 32-QAM, 64-QAM and higher.

In Example 36, the subject matter of any one of Examples 28-35 can optionally include: estimating a channel; and detecting the transmit symbol based on the channel.

In Example 37, the subject matter of Example 36 can optionally include: detecting the transmit symbol x based on solving the following linear system of equations: $H^HHx = H^Hy.$ , where H denotes the channel and y denotes the receive symbol.

Example 38 is a device for detecting a transmit symbol by a digital beamforming receiver device comprising a plurality of receive signal paths connectable to respective antenna ports of an antenna array, the device comprising: a radio frequency (RF) front-end configured to convert the RF signal to an analog baseband or intermediate frequency signal, and means for converting, by an analog-to-digital converter (ADC) of the respective receive signal path, the analog signal into digital domain; and means for detecting, by a coordinate descent detection logic, a transmit symbol based on the ADC outputs of the plurality of receive signal paths.

In Example 39, the subject matter of Example 38 can optionally include: means for detecting the transmit symbol based on a Dichotomous Coordinate Descent algorithm (DCD).

Example 4037 is a multiple-input multiple-output (MIMO) detection system, comprising: a first logic system component configured to determine a gram matrix, $H^H H$ of a MIMO channel, H; a second logic system component configured to determine a product of the Hermitian MIMO channel, $H^H$ and a receive symbol, y; and a third logic system component configured to detect a transmit symbol, x based on a Coordinate Descent algorithm (CD) applied to outputs of the first logic and the second logic.

In Example 41, the subject matter of Example 40 can optionally include that the third logic system component is configured to detect the transmit symbol based on one of the following variants of DCD: Leading DCD, Sequential DCD, Sequential DCD with bound, Leading DCD with bound.

Example 42 is a computer readable non-transitory medium on which computer instructions are stored which when executed by a computer cause the computer to perform the method of any one of Examples 28 to 37.

In addition, while a particular feature or aspect of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Furthermore, it is understood that aspects of the disclosure may be implemented in discrete circuits, partially integrated circuits or fully integrated circuits or programming means. Also, the terms "exemplary", "for example" and "e.g." are merely meant as an example, rather than the best or optimal.

Although specific aspects have been illustrated and described herein, it will be appreciated by those of ordinary skill in the art that a variety of alternate and/or equivalent implementations may be substituted for the specific aspects shown and described without departing from the scope of the present disclosure. This application is intended to cover any adaptations or variations of the specific aspects discussed herein.

Although the elements in the following claims are recited in a particular sequence with corresponding labeling, unless the claim recitations otherwise imply a particular sequence for implementing some or all of those elements, those elements are not necessarily intended to be limited to being implemented in that particular sequence.

**Claims**

1. A digital beamforming receiver device, comprising:

    a plurality of receive signal paths connectable to respective antenna ports of an antenna array, each receive signal path comprising:

        a radio frequency (RF) front-end configured to convert a received RF signal to an analog baseband; and
        an analog-to-digital converter (ADC) configured to convert the analog signal into digital domain; and

    a coordinate descent detection logic, configured to detect a transmit symbol based on the ADC outputs of the plurality of receive signal paths.

2. The digital beamforming receiver device of claim 1,
    wherein each receive signal path comprises an amplifier coupled between the RF front-end and the ADC, wherein the amplifier is configured to match the RF front-end output signal to a dynamic range of the ADC input.

3. The digital beamforming receiver device of claim 1,
    wherein the ADC comprises a low resolution ADC.

4. The digital beamforming receiver device of claim 3,
    wherein a resolution of the low resolution ADC is an ADC that does not fully cover the dynamics of the analog signal at its input.

5. The digital beamforming receiver device of one of the preceding claims,
    wherein the antenna array is configured to receive millimeter wave RF signals.

6. The digital beamforming receiver device of one of the preceding claims,

wherein the coordinate descent detection logic is configured to detect the transmit symbol based on a Dichotomous Coordinate Descent algorithm (DCD).

7. The digital beamforming receiver device of claim 6, wherein the coordinate descent detection logic is configured to detect the transmit symbol based on one of the following variants of DCD:

Leading DCD,
Sequential DCD,
Sequential DCD with bound,
Leading DCD with bound.

8. The digital beamforming receiver device of one of the preceding claims, wherein the coordinate descent detection logic is configured to detect the transmit symbol based on a coordinate descent algorithm with binary step size.

9. The digital beamforming receiver device of claim 8, wherein the coordinate descent detection logic is configured to implement multiplications as bit shifts.

10. The digital beamforming receiver device of one of the preceding claims, wherein the coordinate descent detection logic is configured to restrict a size of the detected transmit symbol.

11. The digital beamforming receiver device of claim 10, wherein the size of the detected transmit symbol is not restricted or restricted to an area defined by a predefined constellation.

12. The digital beamforming receiver device of claim 11, wherein the predefined constellation is from the following: 4-QAM, 8-QAM, 16-QAM, 32-QAM, 64-QAM and higher.

13. A method for detecting a transmit symbol by a digital beamforming receiver device comprising a plurality of receive signal paths connectable to respective antenna ports of an antenna array, the method comprising:

converting a received RF signal, by a radio frequency (RF) front-end, to an analog baseband or intermediate frequency signal, and
converting, by an analog-to-digital converter (ADC) of the respective receive signal path, the analog baseband or intermediate frequency signal into digital domain; and
detecting, by a coordinate descent detection logic, a transmit symbol based on the ADC outputs of the plurality of receive signal paths.

14. The method of claim 13, comprising:

detecting the transmit symbol based on a Coordinate Descent algorithm (CD).

15. A computer readable non-transitory medium on which computer instructions are stored which when executed by a computer cause the computer to perform the method of claim 13 or 14.

**Fig. 1**

Fig. 2

**Fig. 3**

400

411

$y$

401

$H^H y$

$H$

412

402

$H^H H$

$H$  $B$  $N_u$  $M_b$

403

Sequential
DCD with
bound

$\hat{x}$

413

**Fig. 4**

500a

**Fig. 5a**

500b

Fig. 5b

**Fig. 6**

700

701     304a     307a     309

301a

⊗

303a

304b

304c

LADC    307b

LO

LADC

LADC    307c

301b

303b

304d

LO

LADC

307d

702

Coordinate
Descent
Detection
Logic

310

**Fig. 7**

800

Mixing RF signal — 801

Converting mixed RF signal into digital domain — 802

Detecting transmit symbol — 803

**Fig. 8**

Europäisches
Patentamt

European
Patent Office

Office européen
des brevets

# EUROPEAN SEARCH REPORT

Application Number

EP 17 19 7841

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ROTH KILIAN ET AL: "Achievable Rate and Energy Efficiency of Hybrid and Digital Beamforming Receivers With Low Resolution ADC", IEEE JOURNAL ON SELECTED AREAS IN COMMUNICATIONS, IEEE SERVICE CENTER, PISCATAWAY, US, vol. 35, no. 9, 1 September 2017 (2017-09-01), pages 2056-2068, XP011659085, ISSN: 0733-8716, DOI: 10.1109/JSAC.2017.2720398 [retrieved on 2017-08-17] | 1-5,8-15 | INV. H04L25/02 H03M1/00 H04B7/08 |
| Y | * the whole document * | 6,7 | |
| X | US 2017/019157 A1 (MO JIANHUA [US] ET AL) 19 January 2017 (2017-01-19) | 1-5,8-15 | |
| Y | * paragraph [0024] - paragraph [0094] * * figures 1-6 * | 6,7 | |
| Y | YURIY V ZAKHAROV ET AL: "Low-Complexity RLS Algorithms Using Dichotomous Coordinate Descent Iterations", IEEE TRANSACTIONS ON SIGNAL PROCESSING, IEEE SERVICE CENTER, NEW YORK, NY, US, vol. 56, no. 7, 1 July 2008 (2008-07-01), pages 3150-3161, XP011216804, ISSN: 1053-587X | 6,7 | TECHNICAL FIELDS SEARCHED (IPC) H04L H03M H04B |
| A | * the whole document * | 1-5,8-15 | |
| A | US 2012/170442 A1 (RAZAVIYAYN MEISAM [US] ET AL) 5 July 2012 (2012-07-05) * paragraph [0025] - paragraph [0066] * * paragraph [0081] - paragraph [0086] * * paragraph [0097] - paragraph [0101] * * figures 1,2,3a,3b,5a,7 * * claims 1-11 * | 1-15 | |

-/--

The present search report has been drawn up for all claims

| Place of search | Date of completion of the search | Examiner |
|---|---|---|
| Munich | 19 April 2018 | Kokkinos, Titos |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2013/078927 A1 (RAZAVIYAYN MEISAM [US] ET AL) 28 March 2013 (2013-03-28) <br> * paragraph [0023] - paragraph [0047] * <br> * figures 1-4 * <br> * claims 1-9 * <br> ----- | 1-15 | |

**TECHNICAL FIELDS SEARCHED (IPC)**

The present search report has been drawn up for all claims

| Place of search | Date of completion of the search | Examiner |
|---|---|---|
| Munich | 19 April 2018 | Kokkinos, Titos |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 17 19 7841

This annex lists the patent family members relating to the patent documents cited in the above-mentioned European search report.
The members are as contained in the European Patent Office EDP file on
The European Patent Office is in no way liable for these particulars which are merely given for the purpose of information.

19-04-2018

| Patent document cited in search report | | Publication date | Patent family member(s) | | Publication date |
|---|---|---|---|---|---|
| US 2017019157 | A1 | 19-01-2017 | KR<br>US | 20170008143 A<br>2017019157 A1 | 23-01-2017<br>19-01-2017 |
| US 2012170442 | A1 | 05-07-2012 | NONE | | |
| US 2013078927 | A1 | 28-03-2013 | US<br>WO | 2013078927 A1<br>2013044824 A1 | 28-03-2013<br>04-04-2013 |

EPO FORM P0459

For more details about this annex : see Official Journal of the European Patent Office, No. 12/82